# EUROPEAN PATENT SPECIFICATION

(11) **EP 2 467 741 B1**
(45) Date of publication and mention of the grant of the patent: **27.05.2015**
(21) Application number: 10752519.8
(22) Date of filing: 20.08.2010
(51) Int. Cl.: G02B 1/10, G03F 7/20, G21K 1/06, G02B 5/08, B82Y 10/00

(54) **A REFLECTIVE OPTICAL ELEMENT AND METHOD OF PRODUCING IT**
REFLEKTIERENDES OPTISCHES ELEMENT UND VERFAHREN ZU SEINER HERSTELLUNG
ÉLÉMENT OPTIQUE RÉFLÉCHISSANT ET MÉTHODE DE FABRIQUER LE MÊME

(30) Priority: 21.08.2009 DE 102009043824
(43) Date of publication of application: 27.06.2012
(73) Proprietor: Carl Zeiss SMT GmbH, 73447 Oberkochen (DE); ASML Netherlands BV, 5504 DR Veldhoven (NL)
(72) Inventor: VAN KAMPEN, Maarten, NL-5612 DZ Eindhoven (NL); EHM, Dirk, Heinrich, 73466 Lauchheim (DE); VERBERK, Rogier, NL-2496 NG Den Haag (NL); HUIJBREGTSE, Jeroen, NL-4818 TS Breda (NL)
(74) Representative: Werner & ten Brink
(86) International application number: PCT/EP2010/005121
(87) International publication number: WO 2011/020623

(56) References cited:
- EP-A1- 1 154 289
- WO-A2-2008/034582
- JP-A- 11 020 034
- JP-A- 2005 244 015
- US-A- 4 085 248
- US-A1- 2002 051 124
- US-A1- 2002 084 425
- US-A1- 2003 132 537

## Description

The present invention relates to a reflective optical element for the extreme ultraviolet and soft X-ray wavelength range with a reflective surface with an uppermost layer. The present invention further relates to an EUV lithography device with a reflective optical element, to an illumination system, in particular for an EUV lithography device, with a reflective optical element and to a projection system, in particular for an EUV lithography device, with a reflective optical element. The present invention further relates to a method of producing a reflective optical element with a reflective surface with an uppermost layer.

In EUV lithography devices, reflective optical elements for the extreme ultraviolet (EUV) or soft X-ray (SX) wavelength range (e.g. wavelengths of between approximately 5 nm and 20 nm) such as, for instance photomasks or multilayer mirrors, are used for the lithography of semiconductor components. Because EUV lithography devices usually comprise a plurality of reflective optical elements, the latter must have the greatest possible reflectivity, in order to ensure a sufficiently high level of total reflectivity. The reflectivity and service life of the reflective optical elements may be reduced by contamination of the optically used reflective surface of the reflective optical elements, which occurs due to the shortwave radiation combined with residual gases in the operating atmosphere. Because a plurality of reflective optical elements are normally disposed one after another in an EUV lithography device, even relatively minor contamination of each individual reflective optical element has a relatively large effect on the total reflectivity.

Contamination may occur due to moisture residue, for example. In this case, water molecules are split by the EUV and SX radiation and the resulting oxygen radicals oxidize the optically active surfaces of the reflective optical elements. A further source of contamination are polymers, which may originate, for example, from the vacuum pumps used in EUV lithography devices or from residues of resists, which are used on the semiconductor substrates being structured, and which lead to carbon contamination on the reflective optical elements under the influence of operating radiation. Attempts are made to manage these types of contamination, firstly through targeted adjustment of the residual gas atmosphere within the EUV lithography devices and secondly through protective layers on the optically active surfaces of the reflective optical elements.

While oxidative contamination is usually irreversible, carbon contamination in particular can be removed by treatment with atomic hydrogen, in which the atomic hydrogen reacts with the carbonic residues to create volatile compounds. Atomic hydrogen may be formed under the influence of operational radiation within the EUV lithography device through the splitting of molecular hydrogen. Mainly, ions are generated in the residual gas atmosphere by EUV/SX radiation and these ions interact with hydrogen molecules and split them into atomic hydrogen. However, preference is given to the use of cleaning units, in which molecular hydrogen is split into atomic hydrogen at, for example, a glow filament. They enable the amount of atomic hydrogen to be controlled and the atomic hydrogen to be introduced into the EUV lithography device as close as possible to the optically active surfaces requiring cleaning of the reflective optical elements.

JP 2005244015 A discloses a reflective optical element, on which a carbon film is formed under the influence of EUV radiation due to contamination substances, which can comprise organic compounds on the surface of the reflective optical element. The carbon layer can be removed by UV radiation that decomposes the carbon film to volatile substances in the presence of oxygen, peroxide, hydrogen or water.

JP 11020034 A discloses an optical element reflecting radiation at wavelengths between 240 nm and 500 nm. On the surface of the optical element, a monomolecular layer is applied which comprises a silane compound. The monomolecular layer is to repel water and prevent adhesion of contamination.

It has turned out, however, that cleaning units can also lead to contamination, particularly due to metals that originate predominantly from the cleaning units themselves or are dissolved away during a chemical reaction with the atomic hydrogen from materials or components within EUV lithographic devices, in particular as volatile metal hydrides, and that are then deposited in metallic form on the optical elements.

It is therefore an object of the present invention to present measures for controlling contamination due to metal deposition, as is caused, for example, by cleaning with atomic hydrogen.

This object is achieved by means of a reflective optical element for a wavelength range between 5 nm and 20 nm with a reflective surface with an uppermost layer, in which the uppermost layer consists of one or more organic silicon compounds with a carbon-silicon and/or silicon-oxygen bond to form a coherent layer on the surface of the reflective optical element.

It has turned out that protective layers on reflective optical elements for the EUV and SX wavelength range, which contain these types of organic silicon compounds, display, surprisingly, both good resistance to cleaning with atomic hydrogen and also a low adhesion rate for metal hydrides or metals. Similarly to uppermost layers of silicon, silicon dioxide or carbon, no metal contamination is detected for these protective layers within the range of the accuracy of usual surface analysis methodes. As is generally known, however, uppermost layers of silicon, silicon dioxide or carbon suffer severe to very severe attack by atomic hydrogen, which is also one of the reasons for using atomic hydrogen to remove carbonic contamination. It has now emerged, surprisingly, that as with uppermost layers made from a metal or metal alloy, as are frequently used with reflective optical elements for the EUV or SX wavelengths, organic silicon compounds with a carbon-silicon and/or silicon-oxygen bond are attacked to an only negligible extent by cleaning with atomic hydrogen.

In the case of organic silicon compounds with a carbon-silicon and/or silicon-oxygen bond, these may involve, for example, any organo-silicon compounds or siloxanes and/or polysiloxanes, insofar as they are able to form a coherent layer on the surface of a reflective optical element. Preferably, compounds are involved that are made from silicon, oxygen and hydrocarbons or hydrogen.

The object is furthermore achieved by an EUV lithography device, an illumination system, in particular for an EUV lithography device, and a projection system, in particular for an EUV lithography device, with a reflective optical element as described above.

In addition, the object is achieved by a method of producing a reflective optical element, as just described, comprising the steps:
- introduction of a reflective optical element with a reflective surface into a chamber;
- introduction of a gas containing one or more organic silicon compounds with a carbon-silicon and/or silicon-oxygen bond;
- impingement of the reflective surface with electro-magnetic radiation and/or charged particles.

Advantageous embodiments are found in the dependent claims.

The present invention will be explained in greater detail with reference to a preferred exemplary embodiment. For this purpose:
- Figure 1: shows a schematic embodiment of an EUV lithography device with an illumination system and a projection system;
- Figures 2a-c: show schematic representations of different embodiments of reflective optical elements;
- Figures 3a,b: shows flow charts for two embodiments of the method for producing reflective optical elements;
- Figure 4: shows a graph depicting the influence of atomic hydrogen on a protective coating containing one or more organic silicon compounds with a carbon-silicon and/or silicon-oxygen bond; and
- Figure 5a,b: shows reflectivity curves for reflective optical elements with uppermost layers of different materials and a wavelength of 13.5 nm as a function of the carbon contamination.

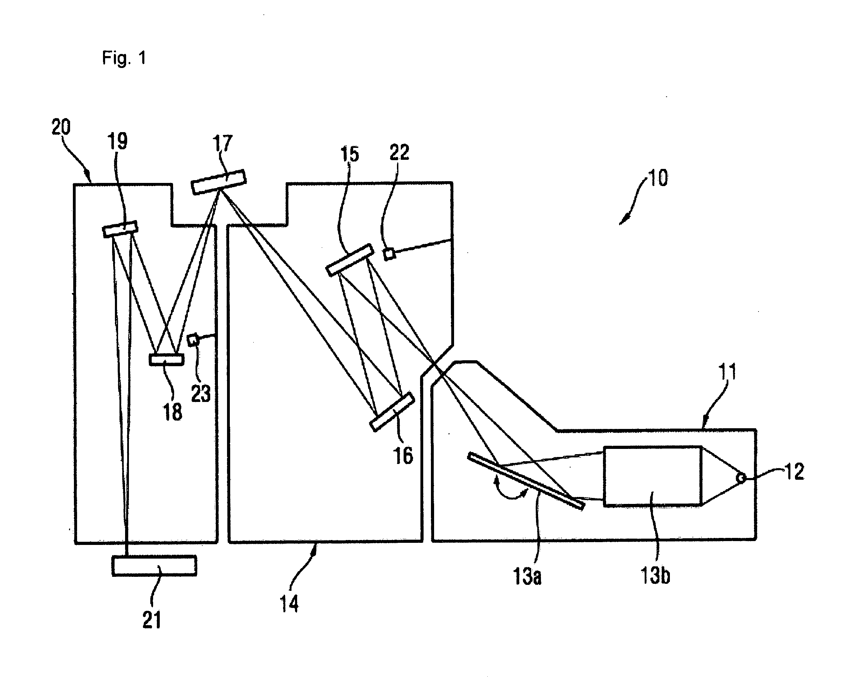

Figure 1, schematically represents an example of an EUV lithography device 10. Essential components are the beam-shaping system 11, the illumination system 14, the photomask 17 and the projection system 20. The EUV lithography device 10 is operated under vacuum conditions, so that the EUV or SX radiation is absorbed internally as little as possible.

By way of example, a plasma source or else a synchrotron may act as the radiation source 12. For the wavelength range of roughly 5 nm to 20 nm, the emerging radiation is firstly concentrated in the collimator 13b. In addition, the desired operating wavelength is filtered out with the aid of a monochromator 13a by varying the angle of incidence. In the aforementioned wavelength range, the collimator 13b and the monochromator 13a are normally embodied as reflective optical elements. Collimators are often reflective optical elements embodied in shell-shaped fashion, in order to achieve a focusing or collimating effect. The radiation is reflected on the concave surface, wherein a multilayer system is often not used to achieve reflection on the concave surface, since as broad a wavelength range as possible is to be reflected. The filtering out of a narrow wavelength band by reflection takes place at the monochromator, often with the help of a grid structure or a multilayer system.

The operating beam conditioned with regard to wavelength and spatial distribution in the beam-shaping system 11 is then introduced into the illumination system 14. In the example illustrated in Figure 1, the illumination system 14 has two mirrors 15, 16. The mirrors 15, 16 direct the beam onto the photomask 17, which shows the structure that is intended to be imaged onto the wafer 21. The photomask 17 is likewise a reflective optical element for the EUV and SX wavelength range, said element being exchanged depending on the production process. With the aid of the projection system 20, the beam reflected from the photomask 17 is projected onto the wafer 21 and the structure of the photomask is thereby imaged onto said wafer. In the example illustrated, the projection system 20 has two mirrors 18, 19. It should be pointed out that both the projection system 20 and the illumination system 14 can likewise each have just one or else three, four, five or more mirrors.

In the example illustrated here, in order to clean the first mirrors 15, 18 of the illumination system 14 or projection system 20 in the beam path of contamination, cleaning heads 22, 23 are provided. Since the greatest beam load in each case is applied to the first mirror of a module in the beam path, the greatest contamination can be expected there, particularly when it comes to carbonic contamination. It goes without saying that cleaning heads can also be provided on other reflective optical elements, such as on all mirrors. In the example shown here, the cleaning heads 22, 23 display an intake for molecular hydrogen and also, for example, a glow filament, where the molecular hydrogen flows past, so that it is split by the high temperature of the incandescent glow filament into atomic hydrogen. The atomic hydrogen thereby created is released close to the mirror 15, 18 to be cleaned into the residual gas atmosphere of the EUV lithography device 10, namely, preferably immediately onto the mirror surface of the mirror to be cleaned, so that it converts carbonic contamination on the mirrors 15,18 into volatile hydrocarbon compounds. Atomic hydrogen can also develop due to the interaction of the EUV and SX radiation used during operation of the EUV lithography device or ions generated by it with molecular hydrogen contained in the residual gas atmosphere.

When operating cleaning heads 22, 23, metals such as zinc, manganese, silver, lead, sodium or tin may escape into the residual gas atmosphere or may be sputtered by the resulting hydrogen radicals or other high-energy particles from components within the EUV lithography device 10, such as the housing of the cleaning heads 22, 23, the mirror holders, the mirror substrates, contacts, etc.. To a significant extent, they are dissolved away by the existing atomic hydrogen by chemical processes, e.g. in the form of hybrids. Hence, for example, zinc or manganese often originate from the cleaning heads themselves, while lead or silver may come from contacts, such as soldered joints, for example. Sodium and tin may come from plasma radiation sources, among other things. The metals may in turn be deposited on the optically active surfaces of the reflective optical elements and thereby affect their reflectivity in terms of magnitude and in relation to homogeneity over the irradiated area, which leads to imaging defects.

In order to limit the negative effect of such metal contamination on reflectivity, reflective optical elements are used in the EUV lithography device 10, in which the uppermost layer of the reflective surface displays one or more organic silicon compounds with a carbon-silicon and/or silicon-oxygen bond. In the example shown in Figure 1, it is the mirrors 16, 18 that are particularly at risk from the proximity of the cleaning heads 22, 23. If necessary, other or all mirrors and possibly also the other reflective elements, such as the photomask 17 or collimator 13b or monochromator 13a, may be equipped in this way.

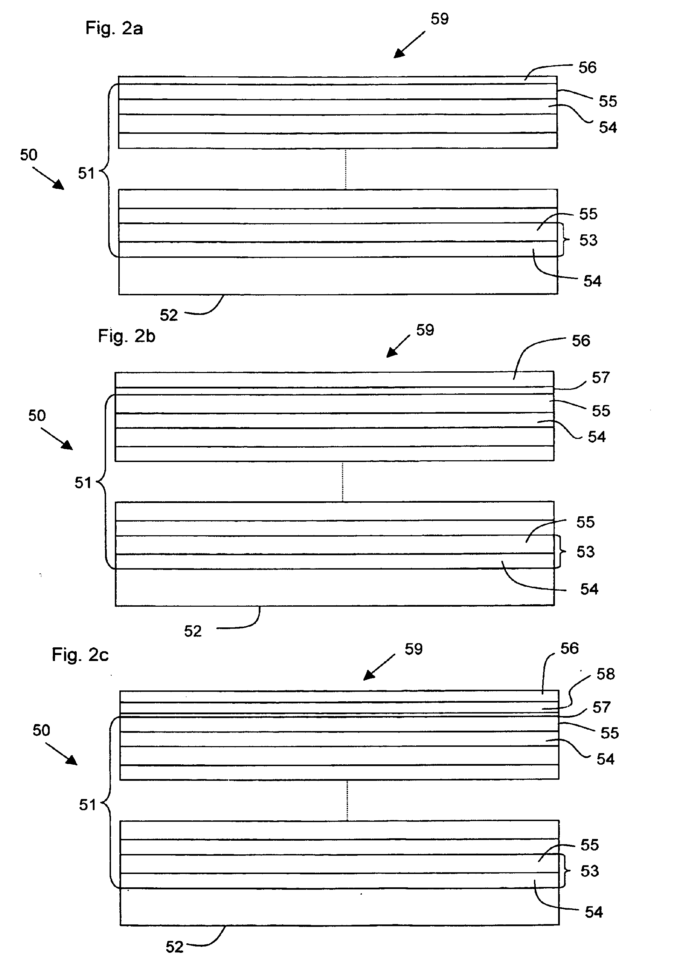

Figures 2a,b show schematically exemplary embodiments of such reflective optical elements 50. In the examples illustrated, the reflective optical elements are based on a multilayer system 51. This involves alternating layers of a material with a higher real part of the refractive index at the operating wavelength (also referred to as spacers 55) and a material with a lower real part of the refractive index at the operating wavelength (also referred to as absorbers 54), wherein an absorber/spacer pair forms a stack 53. This, to a certain extent, simulates a crystal, wherein the absorber layers correspond to the lattice planes, where Bragg reflection takes place. The thicknesses of the individual layers 54, 55, as well as of the repeating stacks 53, may be constant over the entire multilayer system 51 or they may vary, depending on the reflection profile to be achieved. The reflection profile may also be influenced in a targeted manner by adding to the base structure made up of absorbers 54 and spacers 55 additional more or less absorbent materials, in order to increase the maximum possible reflectivity at the respective operating wavelength. In addition, in many stacks absorber and/or spacer materials can be exchanged for one another or the stacks may be constructed from more than one absorber and/or spacer material. The absorber and spacer materials may display constant or also varying thicknesses across all stacks, in order to optimise reflectivity. In addition, intermediate layers may be provided as diffusion barriers, for example.

In particularly preferred embodiments, the reflective optical element 50 has a reflective surface 59 comprising a multilayer system 51 based on alternating layers 54, 55 of at least two materials with different real parts of the refractive index at a wavelength in the extreme ultraviolet and soft X-ray wavelength range, said multilayer system 51 being designed for good reflectivity at a wavelength in the extreme ultraviolet and soft X-ray wavelength range. Advantageously, the reflective optical element 50 is operated at this wavelength, in particular for lithography in the extreme ultraviolet and soft X-ray wavelength range.

The multilayer system 51 is applied on a substrate 52 and creates a reflective surface 59. Materials with a low thermal expansion coefficient are preferably chosen as substrate materials. Glass ceramics are suitable, for example. However, they may likewise be a contamination source for metals under EUV or SX radiation or, in particular, under the influence of atomic hydrogen used to clean the optical surface.

On the reflective surface 59 an uppermost layer, which has one or more organic silicon compounds with a carbon-silicon and/or silicon oxygen bond, is applied as a protective layer 56.

The organic silicon compounds with a carbon-silicon and/or silicon-oxygen bond may be any organo-silicon compounds, for example, insofar as they are able to form a coherent layer on the surface of a reflective optical element. These are preferably compounds made up of silicon, oxygen and hydrocarbons or hydrogen. Particularly preferable are siloxanes, particularly polysiloxanes, wherein longer-chain polymerized siloxanes and/or shorter-chained polymerised siloxanes and siloxane monomers may exist alongside one another on a reflective optical element.

The basic structure of the siloxanes is based on a silicon-oxygen bond. A silicon atom may be combined with between one and four oxygen atoms. The siloxane units are referred to accordingly as mono-, di-, tri- or tetrafunctional. The silicon is combined with hydrocarbon residues or hydrogen atoms via the valence electrons not saturated with the oxygen bond. Alkyl or phenyl residues are preferred.

In the case of polymerization, linear polysiloxanes may be formed from chains of difunctional siloxane units and monofunctional siloxane units as end units.

Cyclical polysiloxanes are formed from closed chains of difunctional siloxane units. When forming branched polysiloxanes, tri- or tetrafunctional siloxane units are used as junction points. If linear or cyclical polysiloxane units are connected via a significant number of tri- or tetrafunctional siloxane units in two or three dimensions, these are referred to as crosslinked polysiloxanes.

It should be noted that a structure based on only tetrafunctional siloxane units is not included within the framework of the present disclosure, as this would be traditional silicon dioxide.

The uppermost layer 56 is preferably applied during production of the reflective optical element 50. This makes it easier to ensure that the uppermost layer 56 covers the entire reflective surface 59, or at least the area of the reflective surface 59 irradiated during use, in order to avoid surface inhomogeneities. Moreover, a given thickness of the uppermost layer 56 can be accurately set more easily, in order that said layer exerts a protective effect without affecting reflectivity too much.

It is also advantageous for reflective optical elements to be equipped with an uppermost layer with one or more organic silicon compounds with a carbon-silicon and/or silicon-oxygen bond in-situ within an EUV lithography device, particularly within its illumination or projection system, by introduction of organic silicon compounds and by irradiation, so that on the surface of the already incorporated reflective optical elements an uppermost layer forms from this. In this way, existing systems or EUV lithography devices can also be retrofitted.

Figure 2a shows an embodiment in which the uppermost layer of one or more organic silicon compounds with a carbon-silicon and/or silicon-oxygen bond is applied immediately onto the final layer of the multilayer system 51, in the present example a spacer layer 55. Likewise, the final layer in the multilayer system 51 may be an absorber layer 54.

It can be found with many material combinations that diffusion or chemical reactions take place at the interface between the uppermost layer 59 and the final layer of the multilayer system 51 below it, said diffusion or chemical reactions altering the structure and thicknesses in this area of the multilayer system, such that the reflectivity deteriorates and in particular the reflectivity over the life of the reflective optical element 50 decreases. In order to counteract this, an additional layer 57 is provided in the embodiment illustrated in Figure 2b as a diffusion barrier and/or protection against chemical reactions. Incidentally, such barrier layers may also be provided within the multilayer system 51 between individual layers or stacks, so that the reflectivity does not diminish with time due to structural changes.

The variant shown in Figure 2c is an embodiment, in which an intermediate layer 58 is provided between the uppermost layer of one or more organic silicon compounds with a carbon-silicon and/or silicon-oxygen bond and the multilayer system 51, said intermediate layer being made from a material usually used for reflective optical elements based on multilayers as a protective layer. The life of the reflective optical element 50 can thereby be further increased.

With a suitable choice of material and thickness for the intermediate layer 58, the reflectivity can also be slightly increased. In the example shown, there is an additional barrier layer 57 between the intermediate layer 58 and the multilayer system 51 to prevent diffusion and/or chemical reactions, wherein the reflectivity can likewise be influenced by the thickness of the barrier layer 57.

For the uppermost layer 56 a thickness in the range of approx. 0.1 nm to 2.5 nm is preferred. Particularly preferable is a thickness that roughly corresponds to a molecular monolayer.

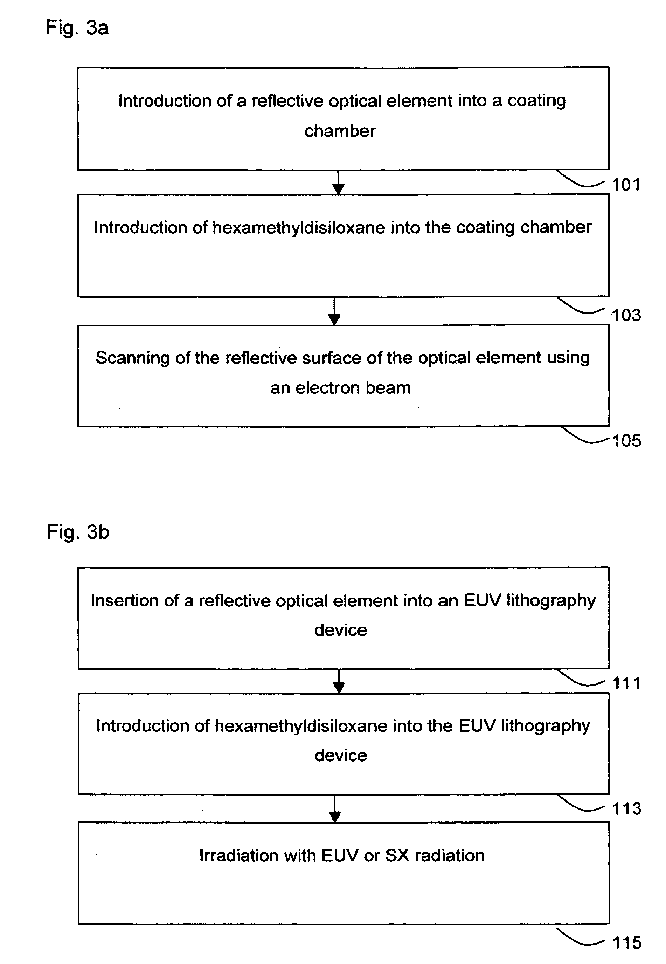

The production of the reflective optical elements described here in an EUV lithography device or in an illumination or projection system of an EUV lithography device is described in greater detail in relation to Figures 3a,b, which depict schematically two embodiments of methods for producing reflective optical elements of this type.

In a first step 101, 111 a reflective optical element with a reflective surface is initially introduced into a chamber. In the example illustrated in Figure 3a, the chamber is a coating chamber; in the example shown in Figure 3b, it is a chamber that is part of an EUV lithography device. The reflective optical element in the example according to Figure 3b is preferably fitted immediately at the location, where it is used in subsequent operations. In both examples, the reflective optical element may be provided with a reflective surface, e.g. with a multilayer system, as described earlier. In particular, reflective optical elements already present in EUV lithography devices may be retrofitted with an uppermost layer, as described here. In the case of the example shown in Figure 3a, a substrate may, by way of an alternative, be introduced into the coating chamber and on said substrate a reflective surface is first made by coating, which is then provided with an uppermost layer as protective layer, which has one or more organic silicon compounds with a carbon-silicon and/or silicon-oxygen bond.

In order to produce this sort of uppermost layer, in a further step 103, 113 a gas containing one or more organic silicon compounds with a carbon-silicon and/or silicon-oxygen bond is introduced into the respective chamber. In the present example, hexamethyldisiloxane was chosen for this. This gaseous siloxane gas can be obtained easily and cheaply and, moreover, has no health risks for humans. However, any number of other siloxane-containing gases or gases with organic substances may also be used, which have carbon-silicon bonds and/or silicon-oxygen bonds. It is also possible to introduce such substances into the respective chamber in solid or liquid form and only convert them to a gaseous state once there.

These substances may deposit as such on the surface of the reflective face. It is assumed that through additional energy application due to the impingement of the reflective surface with electromagnetic radiation and/or charged particles, these substances are converted into smaller fragments, or radicals can be formed, which allows a polymerization of the fragments and/or the substances into longer-chained units through further reactions, so that a layer as coherent as possible is created from a conglomerate of various substances, which display carbon-silicon bonds and/or silicon-oxygen bonds. Depending on the starting substance or starting substance mixture and also the energy application, the layer will vary in composition.

In the examples shown here with hexamethyldisiloxane as the starting substance and energy application by, for example, scanning the reflective surface with an electron beam (step 105) or irradiation with EUV or SX radiation (step 115), it was determined by TOF-SIMS analyses that in the uppermost layer different polysiloxanes with the basic structure [R₂SiO]ₙ were present, wherein the residues R were primarily methyl, ethyl and phenyl groups and n is a natural number ≥ 1. The polysiloxanes display both silicon-carbon bonds and silicon-oxygen bonds. Moreover, various silicic acids with the basic structure H₂ₙ₊₁SiₙO₃ₙ₊₁ where n is a natural number ≥ 1 were detected, which therefore display silicon-oxygen bonds, wherein the oxygen partly belongs to a hydroxyl group.

In relation to the energy application (step 105, 115), it should be pointed out that instead of electron beams, ion beams may also be used. Radiation with charged particles has the advantage that it can be controlled very precisely in relation to the position and dimension of the beam applied and its energy. Particularly in the case of reflective optical elements already incorporated in EUV lithography devices, electromagnetic radiation is advantageously reverted to, as there is often no room for additional particle sources. EUV or SX radiation is used in preference, wherein not necessarily the operating wavelength need be irradiated. Hence, under certain circumstances it may be sufficient to use UV radiation to form the uppermost layer. Since the reflective optical element fitted at its operating position is usually in the beam path, it is guaranteed that the radiation applied will impact on the reflective surface to receive an uppermost layer as described here, and in the presence of substances with silicon-carbon bonds and/or silicon-oxygen bonds will lead to the formation of this uppermost layer. Alternatively, possibly occurring scattered radiation may be sufficient for this. Corresponding solid or liquid substances introduced may also be converted into a gaseous state through scattered radiation or else into a gaseous state, in which they are already present in radicalized form and/or fragment.

Reflective optical elements with an uppermost layer of one or more organic silicon compounds with a carbon-silicon and/or silicon-oxygen bond were tested for the occurence of metallic contamination. Samples, which were produced according to the example shown in Figure 3a, were investigated representatively. The reflective optical elements were introduced into vacuum chambers individually. A ruthenium-coated quartz plate was disposed alongside as reference. As is generally known, ruthenium is often used in traditional reflective optical elements as the uppermost layer, because it displays good resistance to atomic hydrogen, which is used to clean carbon contamination. As metal source, a cavity with a 3 mm diameter was filled with tin at a short distance from the reflective optical element. Twenty cleaning cycles were performed over a 10 min period at a partial pressure of hydrogen of 0.02 mbar. A heated filament at a temperature of roughly 2000 °C was used to generate atomic hydrogen. Upon completion of the twenty cleaning cycles, the surfaces of the reflective optical elements and the comparison samples with the uppermost ruthenium layer were analyzed by means of X-ray Photoelectron Spectroscopy (XPS). While a significant tin contamination in the order of 7-8 at.-% was detected on the comparison samples, any possible tin concentration on the reflective optical elements with one or more organic silicon compounds with a carbon-silicon and/or silicon-oxygen bond was below the detection threshold. The uppermost layer of one or more organic silicon compounds with a carbon-silicon and/or silicon-oxygen bond results in good resistance to metallic contamination, which is comparable with the uppermost layers of carbon or silicon oxide, in which it is assumed that the hybrid dissociation, among other things, is constrained.

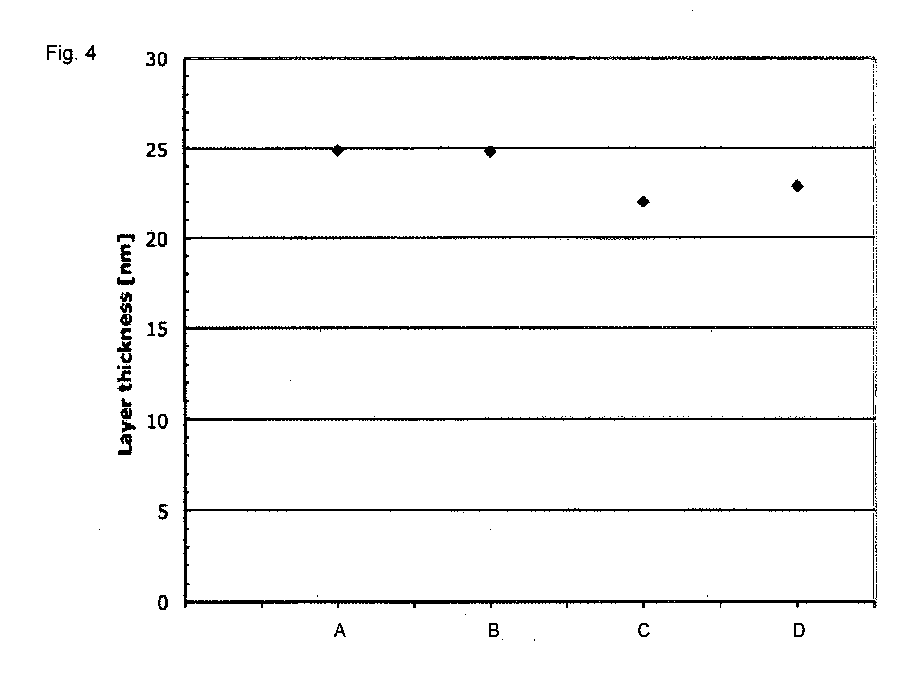

A disadvantage of the uppermost layers being of carbon or silicon dioxide, however, is that they are prone to very severe attacks by atomic hydrogen, which is why atomic hydrogen is used to remove carbonic contamination from the reflective surface of reflective optical elements. Consequently, reflective optical elements with an uppermost layer of one or more organic silicon compounds with a carbon-silicon and/or silicon-oxygen bond were also investigated for their resistance to atomic hydrogen. The summarized results are shown in Figure 4.

Firstly, a sample with an uppermost layer just under 25 nm thick of a wide variety of polysiloxanes, as described above, was produced in a coating chamber. The initial state corresponds to letter A in Figure 4. This sample initially underwent two cleaning cycles of 15 mins each (letter B). In order to generate atomic hydrogen, a glow filament at a temperature of roughly 2000 °C was used at a partial hydrogen pressure of 0.02 mbar. The thickness of the uppermost layer dropped only imperceptibly as a result from 24.86 nm to 24.79 nm. Four 15-min cleaning cycles were then carried out (letter C), which led to a clearer reduction to 21.99 nm. The sample finally underwent a sequence of eleven 15-minute cleaning cycles (letter D), which surprisingly even led to a slight rise again in the thickness of the uppermost layer to 22.86 nm. If these results are compared with the cleaning rate for carbon of 0.1 nm/min, which is achieved with the same test conditions and which would lead to layer reductions by 3 nm, 6 nm and 16.5 nm with the same number of cleaning cycles, the surprisingly good resistance of the reflective optical elements in the invention for cleaning with atomic hydrogen becomes clear.

A further criterion that determines the usability of uppermost layers of particular materials for reflective optical elements for the EUV or SX wavelength range is the maximum reflectivity at the operating wavelength, which is achieved with an uppermost layer of this sort. The reflectivity was therefore also investigated more closely as a result.

The samples are reflective optical elements, which are all provided with a multilayer system based on silicon as spacer and molybdenum as absorber to create a reflective surface. The thickness of the absorber and spacer layers and also the uppermost layers in each case and possibly of intermediate layers is selected in the examples shown, such that the maximum reflectivity in each case is around 13.5 nm.

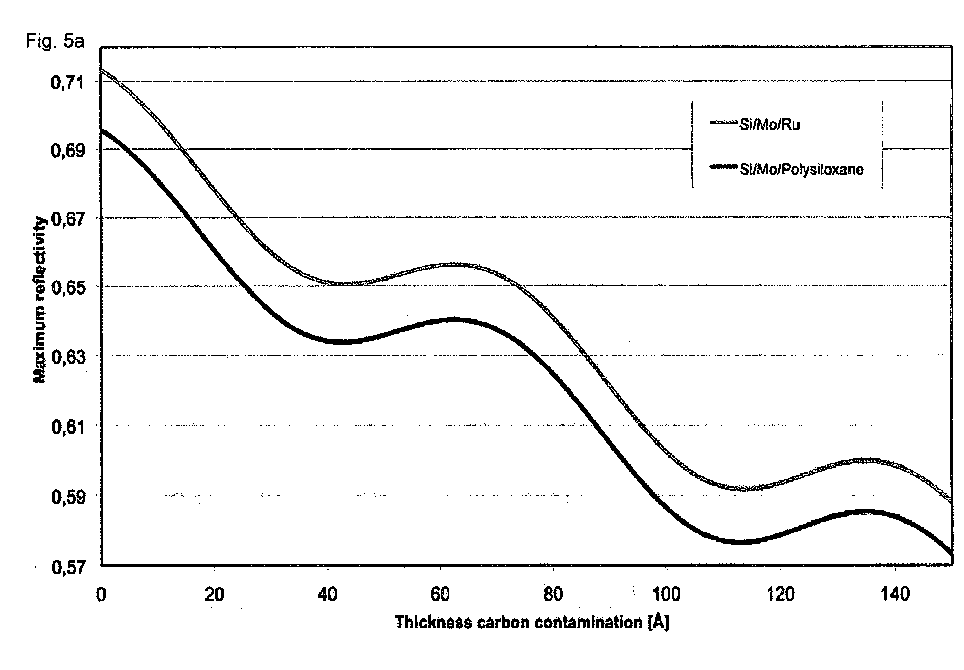

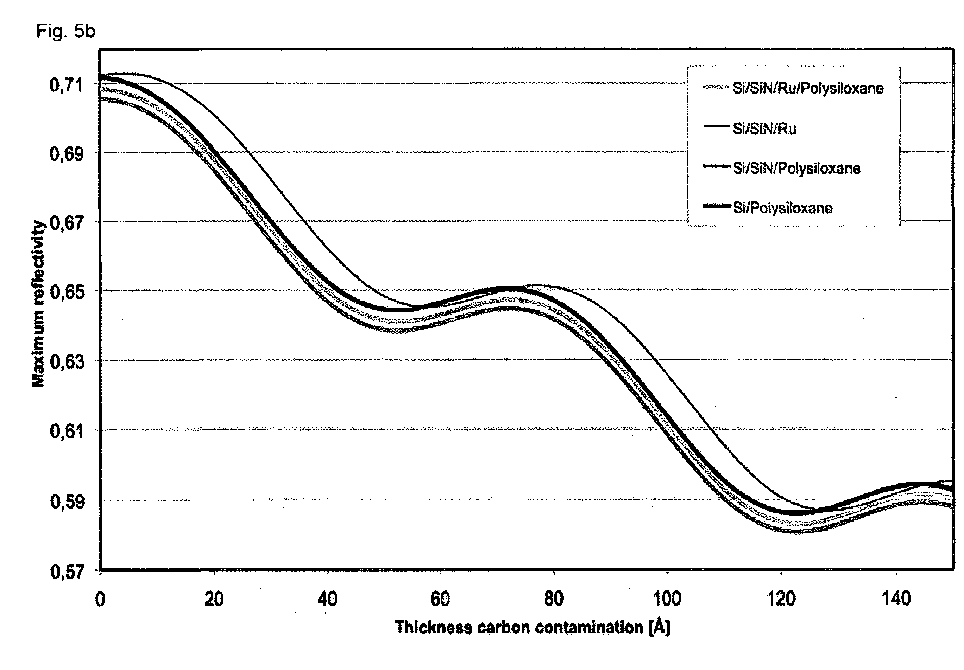

Figures 5a,b show reflectivity curves at a wavelength of approx. 13.5 nm for various examples of reflective optical elements with an uppermost cover layer with one or more organic silicon compounds with a carbon-silicon and/or silicon-oxygen bond as a function of carbon contamination. As an example of reflective optical elements with one or more organic silicon compounds with a carbon-silicon and/or silicon-oxygen bond, the results here are for samples whose uppermost layer is a roughly 1.5 nm thick layer of a mixture of different polysiloxanes and some silicic acids. By way of comparison, the results of reflective optical elements with a traditional ruthenium coating layer are also illustrated, said coating layer also being roughly 1.5 nm thick.

The measured reflectivity curves for two different reflective optical elements are compared in Figure 5a: On a terminating molybdenum layer of the multilayer system is located the aforementioned polysiloxane-containing protective layer on the one hand (black line). The comparative element, on the other hand, has a ruthenium protection layer on a terminating molybdenum layer of the multilayer system (grey line). In the case of uncontaminated reflective optical elements, in other words, a carbon contamination thickness of 0 nm, the maximum reflectivity of the reflective optical element with a polysiloxane-containing protective layer is significantly lower than the maximum reflectivity of the traditional comparative element. It lower for just under 2.5%. Even with increasing carbon contamination, the reflectivity of the reflective optical element with a polysiloxane protective layer remains significantly lower than the maximum reflectivity of the reflective optical element with a ruthenium protective layer.

The measured reflectivity curves for four different reflective optical elements are compared in Figure 5b: A polysiloxane-containing uppermost layer is either applied immediately onto a terminating silicon layer (thick black line) or a silicon nitride (thick dark-grey line) is disposed between the silicon layer and the polysiloxane-containing layer, or a silicon-nitride and a ruthenium layer (thick light-grey line) are disposed. Both silicon nitride and ruthenium are more inert in relation to energy application and cleaning gases than the materials of the multilayer system below them, particularly more inert than silicon, so that the reflective surface is additionally protected. The silicon nitride layer in the present example, which is roughly 1.5 nm thick, is also used as a phase adjustment for the reflected electromagnetic radiation at the transition from the multilayer system to the vacuum. It also acts as a diffusion barrier between silicon and ruthenium. For comparison purposes, a reflective optical element with an uppermost layer of ruthenium and an intermediate layer of silicon nitride on a silicon layer of the multilayer system is examined (thin line).

Without carbon contamination, the element with polysiloxane straight on silicon displays the same maximum reflectivity as a traditional reflective optical element. With high contamination thicknesses, such as, for example, with a contamination thickness of approx. 60-70 nm, an even higher maximum reflectivity is achieved. With a lower maximum reflectivity, the deviation from the maximum reflectivity of the reflective optical element without an uppermost layer is never greater than 2%. By means of customary optimization procedures for the multilayer system design, particularly the choice of layer thicknesses and also the thickness of the uppermost layer with one or more organic silicon compounds with a carbon-silicon and/or silicon-oxygen bond and possibly the introduction of intermediate layers, the reduction in maximum reflectivity over the contamination distribution illustrated can be reduced to under 1%.

If the reflective optical element has an intermediate layer of silicon nitride between the silicon layer of the multilayer system and the polysiloxane-containing uppermost layer, the maximum reflectivity without carbon contamination is lower than for the reference element. However, the deviation is less than 1%. As the carbon contamination rises, the deviation may increase to just under 2% here and there. An improvement in maximum reflectivity without carbon contamination, as well as with rising carbon contamination, can be achieved by introducing a further intermediate layer of ruthenium. This means that the reduction in the maximum reflectivity of the reflective optical element with a polysiloxane-containing uppermost layer compared with a reflective optical element without this sort of uppermost layer can be reduced to well below 2% over the entire carbon contamination distribution. With customary optimisation methods, a reduction in maximum reflectivity of under 1% over the entire distribution can be achieved, even in the case of the reflective optical element with intermediate layers beneath the uppermost layer with one or more organic silicon compounds with a carbon-silicon and/or silicon-oxygen bond.

The reflective optical element with an uppermost layer with one or more organic silicon compounds with a carbon-silicon and/or silicon-oxygen bond on its reflective surface is characterised by high resistance to cleaning with atomic hydrogen and also to metal contamination and thereby facilitates maximum reflectivity comparable with traditional reflective optical elements. This makes them particularly suitable for use in an EUV lithography device employing EUV or SX radiation, particularly in illumination and projection systems of EUV lithograhy devices.

### Reference list

- 10: EUV lithography device
- 11: beam-shaping system
- 12: EUV radiation source
- 13a: monochromator
- 13b: collimator
- 14: illumination system
- 15: first mirror
- 16: second mirror
- 17: mask
- 18: third mirror
- 19: fourth mirror
- 20: projection system
- 21: wafer
- 22: cleaning head
- 23: cleaning head

- 50: reflective optical element
- 51: multilayer system
- 52: substrate
- 53: layer pair
- 54: absorber
- 55: spacer
- 56: protective layer
- 57: barrier layer
- 58: intermediate layer
- 59: reflective surface

- 101-105: process steps
- 111-115: process steps

## Claims

1. A reflective optical element for a wavelength range of roughly 5 nm to 20 nm with a reflective surface with an uppermost layer, wherein the uppermost layer (56) comprising one or more organic silicon compounds with a carbon-silicon and/or silicon-oxygen bond to form a coherent layer on the surface (59) of the reflective optical element (50).

2. The reflective optical element according to claim 1, wherein the uppermost layer (56) comprises one or more siloxanes and/or polysiloxanes.

3. The reflective optical element according to claim 1 or 2, wherein the uppermost layer (56) has a thickness in the range of approx. 0.1 nm to 2.5 nm.

4. The reflective optical element according to one of the claims 1 to 3, wherein the uppermost layer (56) has a thickness, such that the reduction in maximum reflectivity with this uppermost layer (56) compared with the reflectivity without this uppermost layer (56) is less than 2%.

5. The reflective optical element according to one of the claims 1 to 4, wherein the reflective surface (59) comprises a multilayer system (51).

6. The reflective optical element according to one of the claims 1 to 5, wherein the reflective surface (59) comprises a multilayer system (51) based on alternating layers (54, 55) of at least two materials with different real parts of the refractive index at a wavelength in the extreme ultraviolet and soft X-ray wavelength range, said multilayer system (51) being designed for good reflectivity at a wavelength in the extreme ultraviolet and soft X-ray wavelength range.

7. The reflective optical element according to one of the claims 1 to 6, wherein the multilayer system (51) is based on alternating silicon and molybdenum layers (54, 55).

8. The reflective optical element according to one of the claims 1 to 7, wherein it comprises a layer of ruthenium (58) and/or silicon nitride (57) below the uppermost layer (56).

9. An EUV lithography device with a reflective optical element according to claim 1 to 8.

10. An illumination system, particularly for an EUV lithography device, with a reflective optical element according to claim 1 to 8.

11. A projection system, particularly for an EUV lithography device, with a reflective optical element according to claim 1 to 8.

12. A method of producing a reflective optical element according to one of the claims 1 to 8, comprising the steps:
- introduction of a reflective optical element with a reflective surface into a chamber;
- introduction of a gas containing one or more organic silicon compounds with a carbon-silicon and/or silicon-oxygen bond;
- impingement of the reflective surface with electro-magnetic radiation and/or charged particles.

13. The method according to claim 12, wherein a coating chamber is used as the chamber.

14. The method according to claim 12, wherein a chamber of an EUV lithography device is used as the chamber.

15. The method according to one of claims 12 to 14, wherein extreme ultraviolet or soft X-ray irradiation or an electron beam is used.

16. The method according to one of the claims 12 to 15, wherein a siloxane-containing gas is introduced.

## Patentansprüche

1. Reflektierendes optisches Element für einen Wellenlängenbereich ungefähr von 5 nm bis 20 nm mit einer reflektierenden Oberfläche mit einer obersten Schicht, wobei die oberste Schicht (56) eine oder mehrere organische Siliziumverbindungen mit einer Kohlenstoff-Silizium- und/oder einer Silizium-Sauerstoff-Bindung umfasst, um eine kohärente Schicht auf der Oberfläche (59) des reflektierenden optischen Elements (50) zu bilden.

2. Reflektierendes optisches Element nach Anspruch 1, wobei die oberste Schicht (56) ein oder mehrere Siloxane und/oder Polysiloxane umfasst.

3. Reflektierendes optisches Element nach Anspruch 1 oder 2, wobei die oberste Schicht (56) eine Dicke in dem Bereich von ungefähr 0,1 nm bis 2,5 nm hat.

4. Reflektierendes optisches Element nach einem der Ansprüche 1 bis 3, wobei die oberste Schicht (56) eine Dicke hat, so dass die Verringerung der maximalen Reflektivität mit dieser obersten Schicht (56) im Vergleich mit der Reflektivität ohne diese oberste Schicht (56) kleiner als 2 % ist.

5. Reflektierendes optisches Element nach einem der Ansprüche 1 bis 4, wobei die reflektierende Oberfläche (59) ein Mehrschichtsystem (51) umfasst.

6. Reflektierendes optisches Element nach einem der Ansprüche 1 bis 5, wobei die reflektierende Oberfläche (59) ein Mehrschichtsystem (51) auf der Grundlage von sich abwechselnden Schichten (54, 55) von mindestens zwei Materialen mit verschiedenen Realteilen des Brechungsindexes bei einer Wellenlänge im Wellenlängenbereich des Extrem-Ultravioletten und der weichen Röntgenstrahlen umfasst, wobei das Mehrschichtsystem (51) für eine gute Reflektivität bei einer Wellenlänge im Wellenlängenbereich des Extrem-Ultravioletten und der weichen Röntgenstrahlen entworfen ist.

7. Reflektierendes optisches Element nach einem der Ansprüche 1 bis 6, wobei das Mehrschichtsystem (51) auf sich abwechselnden Silizium- und Molybdän-Schichten (54, 55) basiert.

8. Reflektierendes optisches Element nach einem der Ansprüche 1 bis 7, wobei es unter der obersten Schicht (56) eine Schicht aus Ruthenium (58) und/oder Siliziumnitrid (57) umfasst.

9. EUV-Lithographie-Vorrichtung mit einem reflektierenden Element nach Anspruch 1 bis 8.

10. Beleuchtungssystem, besonders für eine EUV-Lithographie-Vorrichtung, mit einem reflektierenden optischen Element nach Anspruch 1 bis 8.

11. Projektionssystem, besonders für eine EUV-Lithographie-Vorrichtung, mit einem reflektierenden optischen Element nach Anspruch 1 bis 8.

12. Verfahren zum Erzeugen eines reflektierenden optischen Elements nach einem der Ansprüche 1 bis 8, das die folgenden Schritte umfasst:
- Einführen eines reflektierenden optischen Elements mit einer reflektierenden Oberfläche in eine Kammer;
- Einführen eines Gases, das eine oder mehrere organische Siliziumverbindungen mit einer Kohlenstoff-Silizium- und/oder einer Silizium-Sauerstoff-Bindung enthält;
- Beaufschlagen der reflektierenden Oberfläche mit elektromagnetischer Strahlung und/oder geladenen Teilchen.

13. Verfahren nach Anspruch 12, wobei eine Beschichtungskammer als die Kammer verwendet wird.

14. Verfahren nach Anspruch 12, wobei eine Kammer einer EUV-Lithographie-Vorrichtung als die Kammer verwendet wird.

15. Verfahren nach einem der Ansprüche 12 bis 14, wobei eine extrem-ultraviolette oder weiche Röntgenstrahlung oder ein Elektronenstrahl verwendet wird.

16. Verfahren nach einem der Ansprüche 12 bis 15, wobei ein Siloxan enthaltendes Gas eingeführt wird.

## Revendications

1. Élément optique réfléchissant pour une gamme de longueurs d'onde d'environ 5 nm à 20 nm avec une surface réfléchissante avec une couche supérieure, la couche supérieure (56) comprenant un ou plusieurs composés de silicium organiques avec une liaison carbone-silicium et/ou silicium-oxygène pour former une couche cohérente sur la surface (59) de l'élément optique réfléchissant (50).

2. Élément optique réfléchissant selon la revendication 1, dans lequel la couche supérieure (56) comprend un ou plusieurs siloxanes et/ou polysiloxanes.

3. Élément optique réfléchissant selon la revendication 1 ou 2, dans lequel la couche supérieure (56) a une épaisseur dans la gamme d'environ 0,1 nm à 2,5 nm.

4. Élément optique réfléchissant selon une des revendications 1 à 3, dans lequel la couche supérieure (56) a une épaisseur telle que la réduction de réflectivité maximale avec cette couche supérieure (56) par rapport à la réflectivité sans cette couche supérieure (56) est inférieure à 2 %.

5. Élément optique réfléchissant selon une des revendications 1 à 4, dans lequel la surface réfléchissante (59) comprend un système multicouche (51).

6. Élément optique réfléchissant selon une des revendications 1 à 5, dans lequel la surface réfléchissante (59) comprend un système multicouche (51) basé sur des couches alternées (54, 55) d'au moins deux matériaux avec des parties réelles de l'indice de réfraction différentes à une longueur d'onde dans la gamme de longueurs d'onde des ultraviolets extrêmes et des rayons X mous, ledit système multicouche (51) étant conçu pour une bonne réflectivité à une longueur d'onde dans la gamme de longueurs d'onde des ultraviolets extrêmes et des rayons X mous.

7. Élément optique réfléchissant selon une des revendications 1 à 6, dans lequel le système multicouche (51) est basé sur des couches alternées de silicium et de molybdène (54, 55).

8. Élément optique réfléchissant selon une des revendications 1 à 7, qui comprend une couche de ruthénium (58) et/ou de nitrure de silicium (57) au-dessous de la couche supérieure (56).

9. Dispositif de lithographie EUV avec un élément optique réfléchissant selon les revendications 1 à 8.

10. Système d'éclairage, en particulier pour un dispositif de lithographie EUV, avec un élément optique réfléchissant selon les revendications 1 à 8.

11. Système de projection, en particulier pour un dispositif de lithographie EUV, avec un élément optique réfléchissant selon les revendications 1 à 8.

12. Procédé de production d'un élément optique réfléchissant selon une des revendications 1 à 8, comprenant les étapes :
- introduction d'un élément optique réfléchissant avec une surface réfléchissante dans une chambre ;
- introduction d'un gaz contenant un ou plusieurs composés de silicium organiques avec une liaison carbone-silicium et/ou silicium-oxygène ;
- percussion de la surface réfléchissante avec un rayonnement électromagnétique et/ou des particules chargées.

13. Procédé selon la revendication 12, dans lequel une chambre de revêtement est utilisée comme chambre.

14. Procédé selon la revendication 12, dans lequel une chambre d'un dispositif de lithographie EUV est utilisée comme chambre.

15. Procédé selon une des revendications 12 à 14, dans lequel une irradiation avec des ultraviolets extrêmes ou des rayons X mous ou un faisceau d'électrons est utilisé.

16. Procédé selon une des revendications 12 à 15, dans lequel un gaz contenant du siloxane est introduit.
